# EUROPEAN PATENT SPECIFICATION

(11) **EP 1 500 984 B1**
(45) Date of publication and mention of the grant of the patent: **26.02.2014**
(21) Application number: 04077003.4
(22) Date of filing: 09.07.2004
(51) Int. Cl.: G03F 7/20

(54) **Article holder for a lithographic apparatus**
Artikelhalter für einen lithographischen Apparat
Support d'article pour un appareil lithographique

(30) Priority: 23.07.2003 EP 03077318
(43) Date of publication of application: 26.01.2005
(73) Proprietor: ASML Netherlands B.V., 5504 DR Veldhoven (NL)
(72) Inventor: Zaal, Koen Jacobus Johannes Maria, 5611 JB Eindhoven (NL); Ottens, Joost Jeroen, 5508 TR Veldhoven (NL); van Empel, Tjarko Adriaan Rudolf, 5643 SC Eindhoven (NL); Hopman, Jan, 2622 EW Delft (NL)
(74) Representative: Slenders, Petrus J. W.

(56) References cited:
- EP-A- 0 683 505
- EP-A- 0 803 904
- EP-A- 1 047 126
- EP-A- 1 378 936
- WO-A-2004/082015
- WO-A-2004/107387
- FR-A- 2 554 288
- US-A- 4 666 291
- US-A- 5 923 408
- US-A- 5 923 521
- US-A1- 2002 008 864

## Description

The present invention relates to lithographic projection apparatus comprising: a radiation system for providing a projection beam of radiation; an article holder comprising a plurality of protrusions defining a protrusion configuration arranged to provide a flat plane of support for supporting a substantially flat article to be placed in a beam path of said projection beam of radiation, the article holder comprising at least one clamping electrode for generating an electrostatic clamping force, for clamping an article against the article holder.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required; and
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid crystal display panels, thin film magnetic heads, etc. The skilled artisan will appreciate that, in the context of such alternative applications, any use of the terms "reticle", "wafer" or "die" in this text should be considered as being replaced by the more general terms "mask", "substrate" and "target portion".

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Further, in the context of this application, the said "article" may be any of the above mentioned terms wafer, reticle, mask, or substrate, more specifically terms such as
- a substrate to be processed in manufacturing devices employing lithographic projection techniques; or
- a lithographic projection mask or mask blank in a lithographic projection apparatus, a mask handling apparatus such as mask inspection or cleaning apparatus, or a mask manufacturing apparatus or any other article or optical element that is clamped in the light path of the radiation system.

In the photolithographic apparatus as hereabove specified, an article is held to the article holder by a clamping electrode. Such electrostatic clamping may be used for example when a substrate is processed in vacuum conditions. This type of processing occurs for instance when the type of irradiation used for photolithographic processes is in the (soft) x-ray region, also referred to as Extreme Ultraviolet (EUV) region. Electrostatic clamping makes use of an electric field between the article holder and the article. In this way, electrostatic forces are used that are present between electrical charge differences in (local) areas of the article holder and the article in order to provide a clamping pressure. Such electrical charge differences occur when for the electrode in the article holder is charged and for example the article is grounded. Otherwise, in the article holder, a plurality of electrodes of opposite voltages may be present, which introduce a likewise opposite charge distribution in the article, leaving no excess charge in the article.

US 5,923,521 discloses an electrostatic chuck to support a wafer, in which the electrode structure contains holes that are concentrically aligned with spacing mask pads that support the wafer. EP-A-803904 and FR-A-2554288 disclose electrostatic chucks having an electrode that is covered by a dielectric layer. The dielectric layer has a non uniform thickness to provide non uniform electrostatic forces.

European patent application EP0947884 describes a lithographic apparatus having an article holder wherein protrusions are arranged to improve the flatness of the article. These protrusions have a general diameter of 0.5 mm and are located generally at a distance of 3 mm away from each other and thereby form a bed of supporting members that support the article. A typical height of the protrusions is 5 µm. However, for electrostatic clamping confgurations, the wafer tends to be supported unevenly, especially near the boundary of the protrusion configuration, due to the termination of support near the boundary edge. This may cause an upward lifting of the wafer or a downward "sagging", which may result in unacceptable imaging quality.

The invention has as one of its objects to provide an article holder according to the preamble, wherein the problem of unevenness of the wafer support of the article holder is addressed and wherein an article is leveled in a controllable way.

In order to achieve said object, there is provided an article holder and a method of preparing it as specified in the claims.

By providing an article holder with a perforated clamping electrode and/or by providing a clamping electrode wherein said clamping electrode comprises a boundary edge that varies a plurality of times within at least one boundary edge line segment that is adjacent to least one protrusion, local height variations of an article due to uneven clamping pressures may be circumvented, since the electrostatic clamping pressure may be locally reduced. In practice, due to boundary effects electrostatic forces are quite hard to predict precisely. Therefore, these perforations and/or contourvariations are provided in an iterative measurement process, wherein local height variations of a wafer are measured, whereupon microperforations or microundulations of the boundary edge are added in order to improve a measured article flatness. In this respect it is noted that the (micro)perforations are "small" with respect to the area spanned by adjacent protrusions, that is, the area of a perforation ranges substantially from 0.01 to 50 % of an avarage area formed by adjacent protrusions. In another aspect it is noted that by varying said boundary edge a plurality of times within at least one boundary edge line segment that is adjacent to least one protrusion, at least is understood as having a locally curved shaped that forms microundulations or curves between two protrusions in a variation that is at least 5 %, preferably 20 % larger than an overall curvature of an electrode boundary edge. Furthermore, this definition it is not intended to be limited to curved shapes but also encompasses shapes that have acute edges such as for instance a zig-zag shape.

In a preferred embodiment, said perforations are generally circular. In another preferred embodiment, said perforations are generally slit-shaped.

The perforations and/or slits may be of a dimension ranging from 0.1 to 0.5 mm.

By providing perforations in this way, said clamping electrode may be a single piece, controlled by a single control voltage.

Embodiments of the invention will now be described, by way of example only, with reference to the accompanying schematic drawings in which corresponding reference symbols indicate corresponding parts, and in which:
Figure 1 depicts a lithographic projection apparatus ;
Figure 2 depicts a plan view of an article holder depicted in Figure 1;
Figure 3 depicts a first embodiment of an article holder of a lithographic projection apparatus of the invention;
Figure 4 depicts a second embodiment of an article holder of a lithographic projection apparatus of the invention;
Figure 5 depicts a detail of the embodiment of Figure 3;
Figure 6 depicts a detail of the embodiment of Figure 4;
Figure 7 depicts a third embodiment of an article holder of a lithographic projection apparatus of the invention;
Figure 8 depicts a fourth embodiment of an article holder of a lithographic projection apparatus of the invention;
Figure 9a end 9b show detailed plan views of clamping electrode boundary edges that are modified according to the invention; and
Figure 10 shows a side view of an article holder showing a fifth embodiment of the invention.

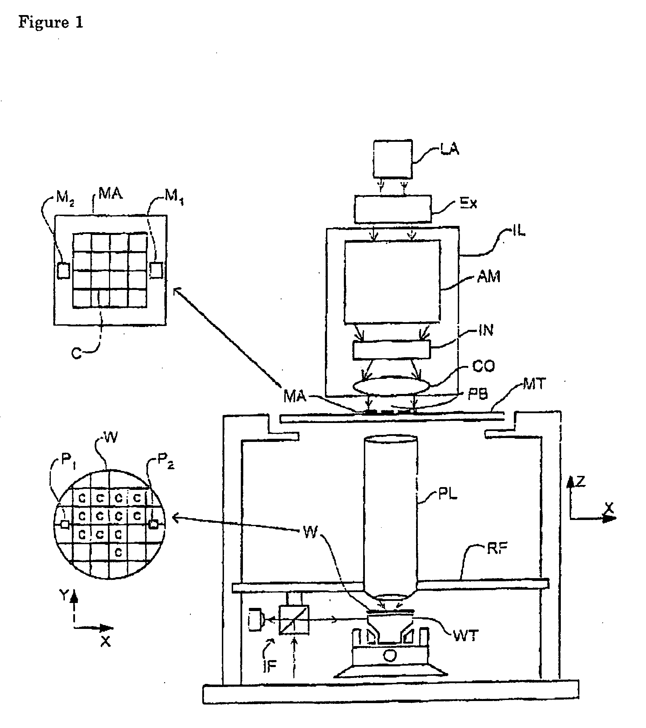

Figure 1 schematically depicts a lithographic projection apparatus. The apparatus comprises:
- a radiation system Ex, IL, for supplying a projection beam PB of radiation (e.g. light in the deep ultraviolet region). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with an article holder for holding a substrate W (e.g. a resistcoated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (e.g. an excimer laser source) produces a beam of radiation. This beam is fed into an ILlumination system (illuminator) IL, either directly or after having traversed conditioning means, such as a beam expander Ex, for example. The illuminator IL may comprise adjusting means AM for setting the outer and/or inner radial extent (commonly referred to as s-outer and s-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

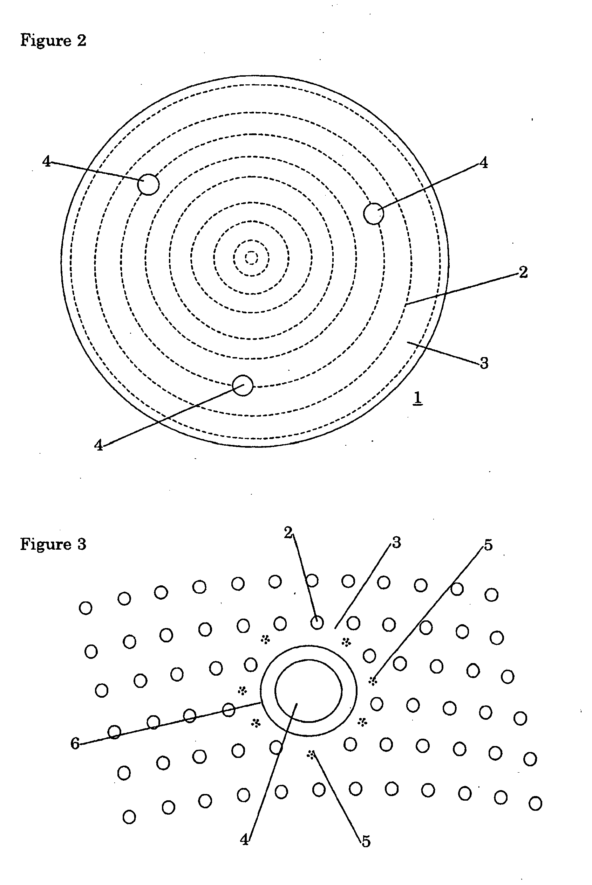

In Figure 2, a schematic plan view is illustrated of an article holder 1 according to the invention. In the figure, by the dotted lines, a plurality of protrusions 2 is pictured, the protrusions oriented in substantially concentric circles. To improve the intelligibility, only a few protrusions are referenced in the pictures. These protrusions 2 have a general diameter of 0.5 mm and are located generally at a distance of 3 mm away from each other and thereby form a bed of supporting members that support the article, such as a wafer or reticle. Furthermore, by reference numeral 3 is indicated a clamping electrode. The clamping electrode 3 may be a conducting layer that is buried in a base plate of the article holder, supporting the protrusions. The clamping electrode 3, when charged, generates an electrostatic clamping force to thereby attract an article against the distal ends of the protrusions 2. In Figure 2, preferably symmetrically in the form of an isosceles triangle, a plurality of through-holes 4 are indicated. The through-holes 4 may serve to accommodate ejection pins (not shown), for ejecting the article from the article holder after a photo-lithographic process has been carried out. Otherwise, in the article holder, through-holes may be present to accommodate feeding means for feeding a backfill gas to the article holder.

Such backfill-gas may be used to fill the spaces formed between the protrusions 2, a base plate that forms a ground layer for supporting the protrusions and the backside of an article, such as a wafer or reticle clamped by the article holder. Such a backfill gas enhances the heat transfer capability from the article to the article holder.

Turning now to Figure 3 there is depicted a detail of article holder 1 near through-hole 4. Although in this description, the invention is demonstrated in the vicinity of such a through-hole 4, the invention may be very well applied in other areas, such as for instance in the vicinity of an irregularity near the perimeter of the article holder (in the art known as "notches"). The invention may even be applied outside the context of an irregular boundary form, since it may serve to resolve local pressure peaks that may arise in a protrusion configuration due to the overall protrusion distribution. However, the presence of through-hole 4 is a good example of a how a local support of the article on the article holder may be variable, since the through-hole introduces an unsupported area of the article that covers the through-hole, and in the direct vicinity of the through-hole. Therefore, the article may deform, depending on the nature of the support and the magnitude of the of the unsupported area, to an even unacceptable proportions, so that a focus error or overlay error runs out of budget. In order to prevent this, according to the invention, clamping electrode 3 comprises perforations 5 for locally decreasing said electrostatic clamping force. In this way, local height variations of wafer due to uneven clamping pressures may be circumvented, since the electrostatic clamping pressure may be locally reduced. Hence the article may be more evenly supported, resulting in a reduced overlay error or focus error.

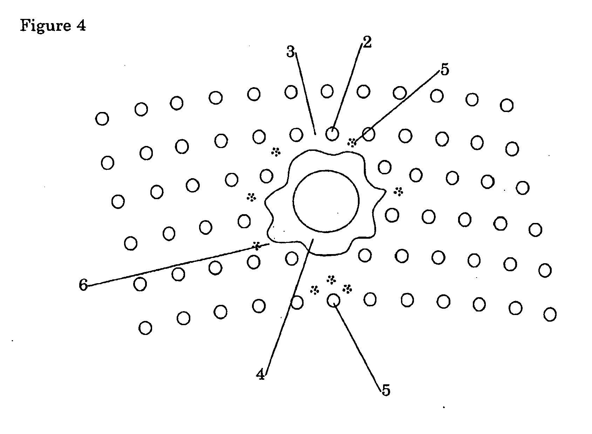

In Figure 4, an alternative embodiment is shown, which wherein the electrostatic clamping force may be even further controlled. Here, in addition, the clamping electrode 3 comprises a boundary edge 6 that is curved locally around at least some of boundary protrusions 2. Such curve may be viewed in general as a plurality of overlapping circles, each oriented with coaxially with respect to a protrusion. The invention may even applied in combination with non-overlapping circles. However, the overlapping circles offer the benefit of a single piece electrostatic clamp, that can be controlled by a single control voltage.

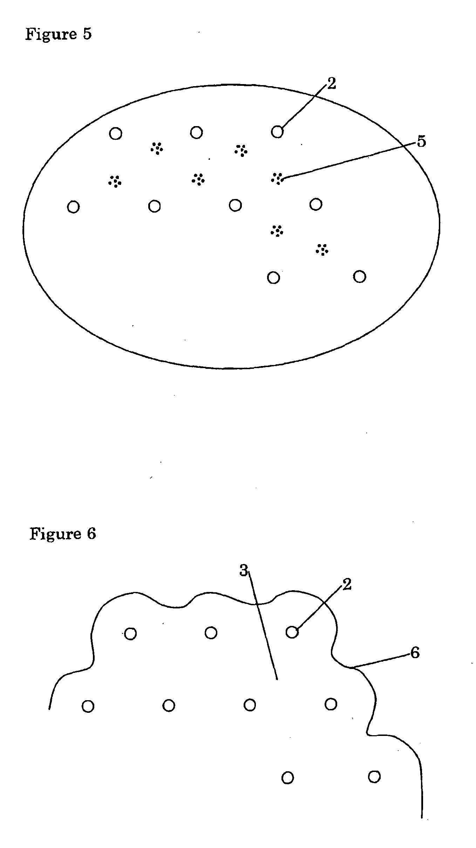

Figure 5 shows a detail of the configuration of Figure 3. In Figure 5, protrusions 2 are shown independent of a specific boundary configuration. Here, the perforations 5 are shown to be present in a central area of a triangle formed by three neighbouring protrusions. In this area, due to the lack of support, an article tends to be clamped too hard, so that the article "sags" and focus and overlay errors are increased. Due to the perforations, such sagging may be prevented, thus decreasing the focus and overlay errors.

Figure 6 shows a detail of Figure 4. Boundary 6 is curved locally, having a radius curvature that is approximately in the order of the distance of the boundary to a next protrusion 2. In this way, local variations of an electric field may be controlled and evened out by locally deforming the boundary edge 6 of the clamping electrode 3.

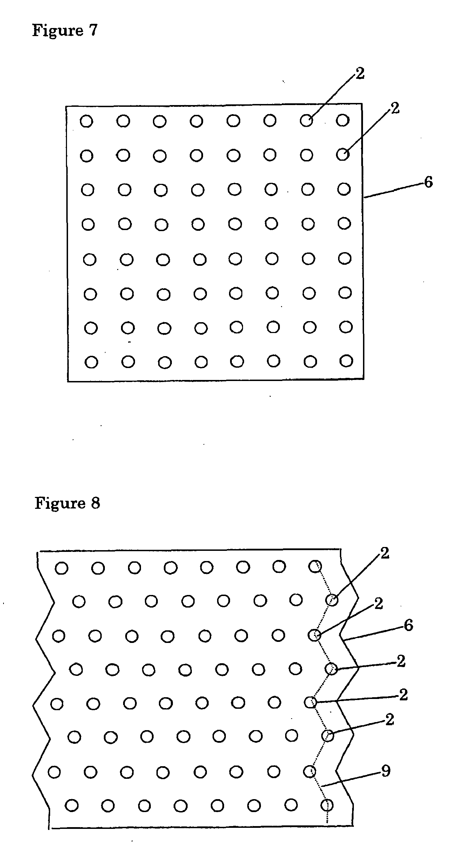

Figure 7 and 8 depict a schematic plan view of a reticle holder for use in EUV-systems, in particular, where the reticle is of a reflective type. These reticle holders 7 are generally square in shape, and are supported by a plurality of protrusions. For such square shapes, the basic configuration may be square (Figure 7) or triangular (Figure 8), the latter having a relative less variation in span between neighbouring burls. According to the invention, the clamping electrode comprises a boundary edge 6 that is shaped according to a circumferential line connecting adjacent boundary protrusions. In Figure 7 this results in a straight line, wherein the improvement is in a somewhat reduced distance of the boundary edge 6 to the half span width of two adjacent protrusions. By such an optimized edge, the effects of overhang can be reduced in relation to a wafer where for example the electrode would extend as far as half the protrusion distance. In Figure 8, an article holder for a reflective square reticle 8 is shown, wherein the protrusion configuration is triangular. In this setup, the boundary edge 6 is optimized, by shaping the edge 6 according to a varying circumferential line 9 connecting adjacent boundary protrusions 2.

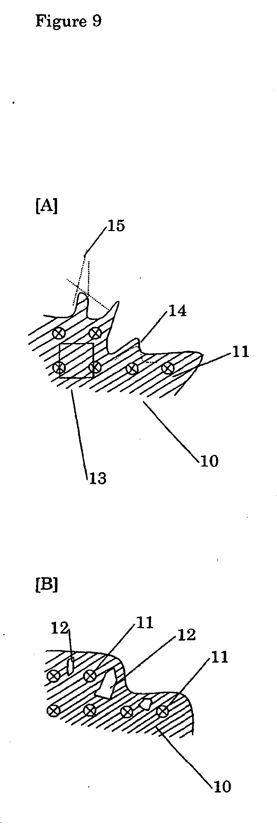

Finally, Figure 9a and 9b show detailed plan views of a clamping electrode boundary edges 6 that are modified according to the invention. In the figure, by the hatched area 10 the clamping electrode is indicated. Furthermore, crossed circles 11 indicate protrusions for supporting an article. Furthermore, the white enclosed areas 12 are perforations for locally decreasing said electrostatic clamping force, in order to achieve a better flatness of the article. From the figure, it is apparent that the areas may have shapes that differ from perfect round shapes. Furthermore, it is apparent that the area of the perforations may vary, more particular, is of an order that is a fraction of an average area 13 indicated schematically in fig. 9 by neighbouring protrusions 2.

Furthermore, from Figure 9 it is apparent that the boundary edge 6 may vary a plurality of times within at least one boundary edge line segment that is adjacent to least one protrusion. Such a line segment is indicated in the picture by reference numeral 14 and has a lenght ranging from 1 to 10 times an average span between two neighbouring protrusions. Furthermore, schematically, tangential lines 15 are indicated tangent to said boundary edge 6. Figure 9 is shown to disclose a boundary edge 6 having a tangential line tangent to said boundary edge that varies in direction so as to follow a local contour formed by the circumferential line around at least some boundary protrusions 2.

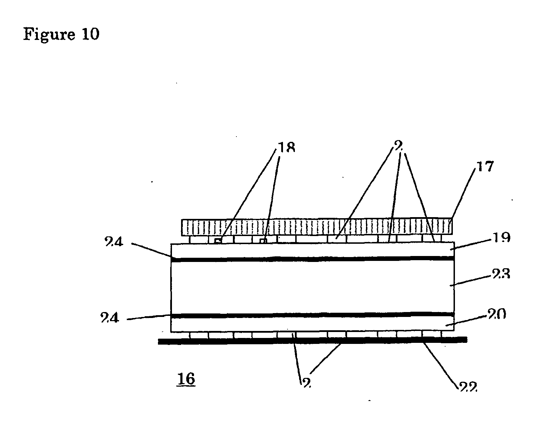

Figure 10 shows a fifth embodiment of the invention, wherein the electric field is locally changed for leveling local height variations of the article, which in this case could be a clamp 16 for clamping a fiducial 17 which is used for alignment purposes of a substrate to be patterned. In this case, a dielectric layer and/or a grounding strip 18 can be provided, that is locally provided covering the electrode. In case of a grounding strip, such could be provided easily by etching or local implanting, in order to provide a local conductive layer that is grounded and covers the electric clamp. The grounded strip prevents the electric field from propagating which will cause a local attenuation which is similar to providing a hole in the clamp. Otherwise, the strip could be a dielectric layer, which increases the electric force exerted on the fiducial. In this example, the fiducial 16 clamp of Figure 10 comprises a top ULE layer 19 of wherein protrusions 2 are arranged to provide a flat support. Likewise, a bottom ULE layer 20 is also provided with protrusions 21, that rest on a supporting part 22, e.g. a moving stage. The clamp is further provided with a central Zerodur layer 23, that is bonded to the ULE layers 19 and 20 by aluminium bonding layer 24 which serve as clamping electrodes.

Whilst specific embodiments of the invention have been described above, it will be appreciated that the invention may be practiced otherwise than as described. The description is not intended to limit the invention.

## Claims

1. An article holder (1) for a lithographic apparatus, comprising a plurality of protrusions (2) defining a protrusion configuration arranged to provide a flat plane of support for supporting a substantially flat article to be placed in a beam path of a beam of radiation within the lithographic apparatus, the article holder comprising at least one clamping electrode (3) for generating an electrostatic clamping force, for clamping an article against the article holder;
**characterized in that** said at least one clamping electrode (3) comprises an electric field changing structure comprising at least one of at least one perforation (5) or microperforation in the clamping electrode (3), a dielectric layer and/or a ground layer (18) covering said clamping electrode, a boundary edge (6) that varies a plurality of times within at least one boundary edge line segment that is adjacent to at least one protrusion (2) and a boundary edge (6) that is shaped according to a circumferential line connecting adjacent boundary protrusions (2), configured such that its configuration locally reduces said electrostatic clamping force to balance locally uneven clamping pressures caused by uneven support of the article in order to reduce local height variations of said article.

2. A lithographic projection apparatus comprising:
a radiation system for providing a projection beam of radiation;
an article holder (1) according to claim 1.

3. A lithographic projection apparatus according to claim 2 including the article holder of claim 1, wherein said perforations (5) are generally circular.

4. A lithographic projection apparatus according to claim 2 including the article holder of claim 1, wherein said perforations (5) are generally slit-shaped.

5. A lithographic projection apparatus according to any one of claims 2 to 4 including the article holder of claim 1, wherein said perforations (5) have a dimension which is a fraction of an average span between two neighbouring protrusions.

6. A lithographic projection apparatus according to claim 5 including the article holder of claim 1, wherein said perforations (5) are ranging from 0.1 to 0.5 mm.

7. A lithographic projection apparatus according to any one of claims 2 to 6 including the article holder of claim 1, wherein said perforations (5) are located central to a triangle formed by three protrusions.

8. A lithographic projection apparatus according to any one of claims 2 to 7 including the article holder of claim 1, wherein said boundary edge (6) is curved locally around at least some boundary protrusions (2).

9. A lithographic projection apparatus according to any one of claims 2 to 8 including the article holder of claim 1, wherein said clamping electrode (3) is a single piece, controlled by a single control voltage.

10. A lithographic projection apparatus according to any one of claims 2 to 9 including the article holder of claim 1, wherein said protrusions (2) are generally cylindrically formed.

11. A method of preparing an article holder according to claim 1, comprising an iterative measurement process in which local height variations of an article supported by the article holder are measured, whereupon at least one said field changing structure (5; 6; 18) is added to the clamping electrode (3) in order to improve a measured article flatness.

## Patentansprüche

1. Ein Objekthalter (1) für ein lithographisches Gerät, der eine Vielzahl von Vorsprüngen (2) beinhaltet, welche eine Vorsprungskonfiguration definieren, die eingerichtet ist, um eine flache Stützebene zum Stützen eines im Wesentlichen flachen Objekts, das in einem Strahlenweg eines Strahls aus Strahlung innerhalb des lithographischen Geräts zu platzieren ist, bereitzustellen, wobei der Objekthalter mindestens eine Spannelektrode (3) zum Erzeugen einer elektrostatischen Spannkraft zum Spannen eines Objekts gegen den Objekthalter beinhaltet;
**dadurch gekennzeichnet, dass** die mindestens eine Spannelektrode (3) eine ein elektrisches Feld ändernde Struktur beinhaltet, die mindestens eines von Folgendem beinhaltet: mindestens eine Perforation (5) oder Mikroperforation in der Spannelektrode (3), eine dielektrische Schicht und/oder eine Masseschicht (18), die die Spannelektrode abdeckt/abdecken, eine Grenzkante (6), die innerhalb mindestens eines Grenzkantenliniensegments, das neben mindestens einem Vorsprung (2) liegt, eine Vielzahl von Malen variiert, und eine Grenzkante (6), die gemäß einer Umfangslinie, welche nebeneinanderliegende Grenzvorsprünge (2) verbindet, geformt ist, so konfiguriert, dass ihre Konfiguration die elektrostatische Spannkraft örtlich reduziert, um durch eine ungleichmäßige Stützung des Objekts verursachte örtlich ungleichmäßige Spanndrücke auszugleichen, um örtliche Höhenvariationen des Objekts zu reduzieren.

2. Ein lithographisches Projektionsgerät, das Folgendes beinhaltet:
ein Strahlungssystem zum Bereitstellen eines Projektionsstrahls aus Strahlung;
einen Objekthalter (1) gemäß Anspruch 1.

3. Lithographisches Projektionsgerät gemäß Anspruch 2, das den Objekthalter von Anspruch 1 umfasst, wobei die Perforationen (5) im Allgemeinen kreisförmig sind.

4. Lithographisches Projektionsgerät gemäß Anspruch 2, das den Objekthalter von Anspruch 1 umfasst, wobei die Perforationen (5) im Allgemeinen schlitzförmig sind.

5. Lithographisches Projektionsgerät gemäß einem der Ansprüche 2 bis 4, das den Objekthalter von Anspruch 1 umfasst, wobei die Perforationen (5) eine Abmessung aufweisen, die ein Bruchteil eines durchschnittlichen Abstands zwischen zwei benachbarten Vorsprüngen ist.

6. Lithographisches Projektionsgerät gemäß Anspruch 5, das den Objekthalter von Anspruch 1 umfasst, wobei die Perforationen (5) von 0,1 bis 0,5 mm reichen.

7. Lithographisches Projektionsgerät gemäß einem der Ansprüche 2 bis 6, das den Objekthalter von Anspruch 1 umfasst, wobei die Perforationen (5) zentral in einem aus drei Vorsprüngen gebildeten Dreieck angeordnet sind.

8. Lithographisches Projektionsgerät gemäß einem der Ansprüche 2 bis 7, das den Objekthalter von Anspruch 1 umfasst, wobei die Grenzkante (6) örtlich um mindestens einige Grenzvorsprünge (2) gekrümmt ist.

9. Lithographisches Projektionsgerät gemäß einem der Ansprüche 2 bis 8, das den Objekthalter von Anspruch 1 umfasst, wobei die Spannelektrode (3) ein einzelnes Stück ist, das durch eine einzelne Steuerspannung gesteuert wird.

10. Lithographisches Projektionsgerät gemäß einem der Ansprüche 2 bis 9, das den Objekthalter von Anspruch 1 umfasst, wobei die Vorsprünge (2) im Allgemeinen zylindrisch gebildet sind.

11. Ein Verfahren zum Herstellen eines Objekthalters gemäß Anspruch 1, das einen iterativen Messprozess beinhaltet, bei dem örtliche Höhenvariationen eines von dem Objekthalter gestützten Objekts gemessen werden, woraufhin mindestens eine besagte feldändernde Struktur (5; 6; 18) der Spannelektrode (3) hinzugefügt wird, um eine gemessene Objektflachheit zu verbessern.

## Revendications

1. Un porte-article (1) destiné à un appareil lithographique, comprenant une pluralité de saillies (2) définissant une configuration de saillies agencées afin de fournir un plan de support plat pour supporter un article substantiellement plat devant être placé dans une trajectoire de faisceau d'un faisceau de rayonnement au sein de l'appareil lithographique, le porte-article comprenant au moins une électrode d'ablocage (3) destinée à générer une force d'ablocage électrostatique, pour abloquer un article contre le porte-article ;
**caractérisé en ce que** ladite au moins une électrode d'ablocage (3) comprend une structure de changement de champ électrique comprenant au moins un élément d'entre au moins une perforation (5) ou microperforation dans l'électrode d'ablocage (3), une couche diélectrique et/ou une couche à la terre (18) recouvrant ladite électrode d'ablocage, un bord de délimitation (6) qui varie une pluralité de fois au sein d'au moins un segment de ligne de bord de délimitation qui est adjacent à au moins une saillie (2) et un bord de délimitation (6) qui est façonné selon une ligne circonférentielle raccordant des saillies de délimitation adjacentes (2), configuré de telle sorte que sa configuration réduise localement ladite force d'ablocage électrostatique pour équilibrer des pressions d'ablocage localement inégales occasionnées par un support inégal de l'article afin de réduire des variations de hauteur locales dudit article.

2. Un appareil de projection lithographique comprenant :
un système de rayonnement destiné à fournir un faisceau de projection de rayonnement ;
un porte-article (1) selon la revendication 1.

3. Un appareil de projection lithographique selon la revendication 2 comportant le porte-article de la revendication 1, dans lequel lesdites perforations (5) sont généralement circulaires.

4. Un appareil de projection lithographique selon la revendication 2 comportant le porte-article de la revendication 1, dans lequel lesdites perforations (5) sont généralement façonnées en fentes.

5. Un appareil de projection lithographique selon l'une quelconque des revendications 2 à 4 comportant le porte-article de la revendication 1, dans lequel lesdites perforations (5) ont une dimension qui est une fraction d'une étendue moyenne entre deux saillies voisines.

6. Un appareil de projection lithographique selon la revendication 5 comportant le porte-article de la revendication 1, dans lequel lesdites perforations (5) sont comprises dans la gamme allant de 0,1 à 0,5 mm.

7. Un appareil de projection lithographique selon l'une quelconque des revendications 2 à 6 comportant le porte-article de la revendication 1, dans lequel lesdites perforations (5) sont situées au centre d'un triangle formé par trois saillies.

8. Un appareil de projection lithographique selon l'une quelconque des revendications 2 à 7 comportant le porte-article de la revendication 1, dans lequel ledit bord de délimitation (6) est incurvé localement autour d'au moins certaines saillies de délimitation (2).

9. Un appareil de projection lithographique selon l'une quelconque des revendications 2 à 8 comportant le porte-article de la revendication 1, dans lequel ladite électrode d'ablocage (3) est une pièce unique, commandée par une tension de commande unique.

10. Un appareil de projection lithographique selon l'une quelconque des revendications 2 à 9 comportant le porte-article de la revendication 1, dans lequel lesdites saillies (2) sont généralement formées de manière cylindrique.

11. Un procédé de préparation d'un porte-article selon la revendication 1, comprenant un processus de mesure itératif dans lequel des variations de hauteur locales d'un article supporté par le porte-article sont mesurées, sur quoi au moins une dite structure de changement de champ (5 ; 6 ; 18) est ajoutée à l'électrode d'ablocage (3) afin d'améliorer la planéité d'un article mesuré.
